(19) Europäisches Patentamt
European Patent Office
Office européen des brevets

(11) EP 4 768 948 A1

(12) EUROPEAN PATENT APPLICATION

(43) Date of publication:
01.07.2026 Bulletin 2026/27

(51) International Patent Classification (IPC):
G01R 31/3835 (2019.01)     G01R 31/52 (2020.01)

(21) Application number: 25179892.2

(52) Cooperative Patent Classification (CPC):
G01R 31/52; G01R 31/3835; G01R 31/396

(22) Date of filing: 30.05.2025

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 30.12.2024 KR 20240200927

(71) Applicants:
• Hyundai Motor Company
Seoul 06797 (KR)
• Kia Corporation
Seoul 06797 (KR)

(72) Inventors:
• JANG, Yoo Hong
18280 Hwaseong-si, Gyeonggi-do (KR)
• LEE, Sung Il
18280 Hwaseong-si, Gyeonggi-do (KR)
• CHOI, Rin
18280 Hwaseong-si, Gyeonggi-do (KR)

(74) Representative: Viering, Jentschura & Partner
mbB
Patent- und Rechtsanwälte
Am Brauhaus 8
01099 Dresden (DE)

Remarks:
Amended claims in accordance with Rule 137(2)
EPC.

(54) METHOD AND APPARATUS FOR PRE-DIAGNOSING SAFETY OF A BATTERY

(57) An apparatus for pre-diagnosing safety of a battery of a vehicle includes a memory configured to store computer-readable instructions and a processor configured to execute the computer-readable instructions. The processor is configured to determine a first voltage and a second voltage for each cell, among a plurality of cells of the battery, during parking of the vehicle. The processor is also configured to determine short circuit resistance for each cell, among the plurality of cells, based on the first voltage and the second voltage determined for each cell. The processor is further configured to determine whether there is a micro short circuit of each cell, among the plurality of cells, based on a comparison between the short circuit resistance determined for each cell and a threshold.

FIG.1

EP 4 768 948 A1

**Description**

**CROSS-REFERENCE TO RELATED APPLICATION**

This application claims the benefit of and priority to Korean Patent Application No. 10-2024-0200927, filed in the Korean Intellectual Property Office on December 30, 2024, the entire contents of which are hereby incorporated herein by reference.

**TECHNICAL FIELD**

The present disclosure relates to a battery diagnosis technology, and more particularly, relates to technologies for diagnosing battery cell micro short circuit growth based on a battery model in an initial stage to perform a pre-diagnosis of safety of a battery.

**BACKGROUND**

Recently, with the spread of battery systems, such as an energy storage system (ESS), an electric vehicle (EV), and a hybrid electric vehicle (HEV), there has been an increase in requirements for evaluating a state of health (SOH) and an abnormal state for a battery of the EV in conjunction with high voltage battery state authentication, EV used car authentication, remanufacturing, and the like.

The SOH indicates how much performance the battery has compared to the initial performance and is used as an index for providing a notification of remaining battery life and a current performance state.

Furthermore, it is required to diagnose an abnormal state on a cell-by-cell basis for a high voltage battery pack mounted in a vehicle or the high voltage battery in a demounted state in various applications, such as issuing a battery certificate as well as remanufacturing, reusing, and recycling the battery of an EV.

One of the most important causes of battery fires is the occurrence of a short circuit. This is because an excessive temperature rise does not occur except for the short circuit in a controlled usage condition as a fire breaks out if the temperature of the battery is greater than a specific threshold.

A defect is detected before the battery is used to configure a pack using only good parts, but there is a possibility that an internal short will occur or grow as the battery deteriorates or impact is applied to the battery. Furthermore, a short circuit may be caused in a usage process, such as very fine foreign substances that are not detected in a defect inspection process, tear, fold, or misalignment.

If a short in the battery grows, the area of the short becomes large. Thus, short resistance decreases, and current flowing in the internal short part increases. If the current flowing in the short part increases, a heating value increases. Thus, the temperature of the short part rises. As a result, if the temperature of the short part is greater than or equal to a threshold, this leads to battery fire. Furthermore, liquid such as a coolant leaked due to a fault or impact of a battery cooling system and/or a waterproof system may cause an external short circuit in a battery module and/or a battery pack to cause fire.

**SUMMARY**

The present disclosure has been made to solve the above-mentioned problems occurring in the prior art while advantages achieved by the prior art are maintained intact.

Aspects of the present disclosure provide a technology for quickly and accurately detecting a battery short circuit in an initial stage.

Aspects of the present disclosure provide a method and an apparatus for pre-diagnosing safety of a battery.

Further aspects of the present disclosure provide a method and an apparatus for pre-diagnosing safety of a battery to calculate short circuit resistance based on a voltage change during parking in each of a plurality of battery cells and detect a battery defect.

Further aspects of the present disclosure provide a method and an apparatus for pre-diagnosing safety of a battery to improve diagnostic resolution to perform a numerical diagnosis via conversion of an open circuit voltage (OCV) change into short circuit resistance upon parking during a certain time or more to more accurately diagnose micro short circuit growth of a battery cell in an initial stage.

The technical problems to be solved by the present disclosure are not limited to the aforementioned problems. Other technical problems not mentioned herein should be more clearly understood from the following description by those having ordinary skill in the art to which the present disclosure pertains.

According to an aspect of the present disclosure, an apparatus for pre-diagnosing safety of a battery of a vehicle is provided. The apparatus includes a memory configured to store computer-readable instructions and a processor configured to execute the computer-readable instructions. The processor is configured to determine a first voltage and a second voltage for each cell, among a plurality of cells of the battery, during parking of the vehicle. The processor is also configured to determine short circuit resistance for each cell, among the plurality of cells, based on the first voltage and the second voltage determined for each cell. The processor is also configured to determine whether there is a micro short circuit of each cell, among the plurality of cells, based on a comparison between the short circuit resistance determined for each cell and a threshold.

According to an embodiment, the processor may be configured to average a plurality of voltage values measured during a first voltage interval to determine the first voltage and average a plurality of voltage values measured during a second voltage interval to determine the second voltage.

According to an embodiment, the second voltage interval may be initiated after a specific time after an end of the first voltage interval.

According to an embodiment, the processor may be configured to end pre-diagnosing of safety of the battery based on determining that at least one of the plurality of voltage values is an error.

According to an embodiment, the processor may be configured to average remaining voltage values, excluding a voltage value that is determined to be an error, to determine the first voltage and the second voltage.

According to an embodiment, the processor may be configured to enter a monitoring interval during the parking of the vehicle after a certain stabilization time elapses after driving of the vehicle ends or charging of the vehicle ends, and determine the first voltage and the second voltage based on voltage values obtained in the monitoring period.

According to an embodiment, the processor may be configured to determine, for each cell among the plurality of cells, a first state of charge (SOC) and a second SOC respectively corresponding to the first voltage and the second voltage based on a predefined open circuit voltage (OCV) /SOC conversion table. The processor may also be configured to determine, for each cell among the plurality of cells, an SOC change amount based on the first SOC and the second SOC, The processor may additionally be configured to determine, for each cell among the plurality of cells, a capacity change amount based on the SOC change amount, cell capacity, and a state of health (SOH). The processor may also be configured to determine a minimum value among the capacity change amounts calculated for the plurality of cells. The processor may further be configured to determine, for each cell among the plurality of cells, a leak capacity change amount based on the minimum value and determine the short circuit resistance based on the leak capacity change amount, a total monitoring time during the parking, and an average value of the first voltage and the second voltage.

According to an embodiment, the processor may be configured to determine a time when an accessory (ACC) and/or an ignition are/is turned on during the parking. The processor may also be configured to add the time to the total monitoring time based on determining that the time is less than a certain threshold time.

According to an embodiment, the threshold may be dynamically set based on a temperature and a state of charge (SOC) of the battery and/or battery cells. The processor may be configured to diagnose a cell among the plurality of cells, the short circuit resistance of which is less than the threshold, as a cell with the micro short circuit to generate a certain fault code.

According to an embodiment, the apparatus may be implemented in a battery management system. The battery management system may be intermittently turned on during the parking to measure a voltage for each battery cell.

According to another aspect of the present disclosure, a method for pre-diagnosing safety of a battery of a vehicle is provided. The method includes determining a first voltage and a second voltage for each cell, among a plurality of cells of the battery, during parking of the vehicle. The method also includes determining short circuit resistance for each cell, among the plurality of cells, based on the first voltage and the second voltage determined for each cell. The method additionally includes determining whether there is a micro short circuit of each cell, among the plurality of cells, based on a comparison between the short circuit resistance determined for each cell and a threshold.

According to an embodiment, determining the short circuit resistance for each cell may include determining a first state of charge (SOC) and a second SOC respectively corresponding to the first voltage and the second voltage based on a predefined open circuit voltage (OCV) /SOC conversion table, determining an SOC change amount based on the first SOC and the second SOC, determining a capacity change amount based on the SOC change amount, cell capacity, and a state of health (SOH), determining a minimum value among the capacity change amounts calculated for the plurality of cells, determining a leak capacity change amount based on the minimum value, and determining the short circuit resistance based on the leak capacity change amount, a total monitoring time during the parking, and an average value of the first voltage and the second voltage.

According to an embodiment, the method may further include determining a time when an accessory (ACC) and/or an ignition are/is turned on during the parking of the vehicle, and adding the time to the total monitoring time based on determining that the time is less than a certain threshold time.

According to an embodiment, the threshold may be dynamically set based on a temperature and a state of charge (SOC) of the battery and/or the battery cells. A cell among the plurality of cells, the short circuit resistance of which is less than the threshold, may be diagnosed as a cell with the micro short circuit to generate a certain fault code.

According to an embodiment, the method may be implemented in a battery management system. The battery management system may be intermittently turned on during the parking of the vehicle to measure a voltage for each cell.

## BRIEF DESCRIPTION OF THE DRAWINGS

The above and other objects, features, and advantages of the present disclosure should be more apparent from the following detailed description taken in conjunction with the accompanying drawings, in which:

FIG. 1 is a drawing for describing a configuration and a driving principle of an electric vehicle according to an embodiment of the present disclosure;
FIG. 2 is a drawing for describing the concept of an open circuit voltage (OCV) and polarization for calculating or otherwise determining a battery voltage according to an embodiment of the present disclosure;
FIG. 3 is a drawing for describing the overall diagnosis process for discriminating whether there is an abnormality in a battery cell according to an embodiment of the present disclosure;
FIG. 4 is a drawing for describing a voltage extraction stage for diagnosing an abnormality in a battery cell according to an embodiment of the present disclosure;
FIG. 5 is a drawing for describing voltage extraction logic in a monitoring interval during parking according to an embodiment of the present disclosure;
FIG. 6 is a drawing for describing a short circuit and short circuit release process of a specific cell in a battery pack according to an embodiment of the present disclosure;
FIGS. 7 and 8 are drawings for describing a method for measuring a first voltage and a second voltage according to an embodiment of the present disclosure;
FIG. 9 is a drawing for describing a configuration of a system for diagnosing an abnormality in a battery cell according to an embodiment of the present disclosure;
FIGS. 10 and 11 are flowcharts for describing a method for pre-diagnosing safety of an electric vehicle according to an embodiment of the present disclosure; and
FIG. 12 illustrates a computing system according to an embodiment of the present disclosure.

## DETAILED DESCRIPTION

Hereinafter, embodiments of the present disclosure are described in detail with reference to the accompanying drawings. In adding the reference numerals to the components of each drawing, it should be noted that the identical components are designated by the identical numerals even when the components are displayed on different drawings. Further, in describing the embodiment of the present disclosure, where it was determined that a detailed description of well-known features or functions would unnecessarily obscure the gist of the present disclosure, the detailed description thereof has been omitted.

In describing the components of the embodiment according to the present disclosure, terms such as first, second, "A", "B", (a), (b), and the like may be used. These terms are merely intended to distinguish one component from another component. The terms do not limit the nature, sequence, or order of the corresponding components. Furthermore, unless otherwise defined, all terms including technical and scientific terms used herein have the same meaning as being generally understood by those having ordinary skill in the art to which the present disclosure pertains. Such terms as those defined in a generally used dictionary should be interpreted as having meanings equivalent to the contextual meanings in the relevant field of art, and should not be interpreted as having ideal or excessively formal meanings unless clearly defined as having such in the present application.

In the present disclosure, when a component, controller, device, element, apparatus, or the like of the present disclosure is described as having a purpose or performing an operation, function, or the like, the component, controller, device, element, apparatus, or the like should be considered herein as being "configured to" meet that purpose or to perform that operation or function. Each component, controller, device, element, module, apparatus, gateway, server, and the like may separately embody or be included with a processor and a memory, such as a non-transitory computer readable media, as part of the apparatus.

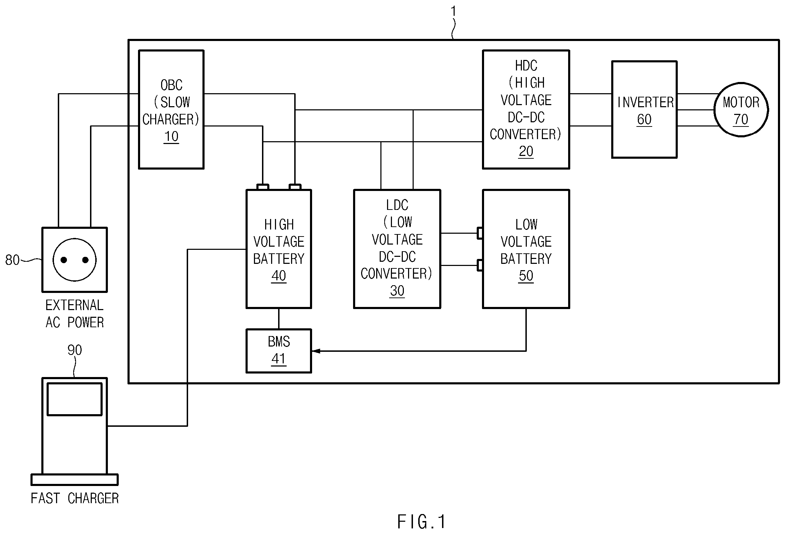

Hereinafter, embodiments of the present disclosure are described in detail with reference to FIGS. 1-12.

FIG. 1 is a drawing for describing a configuration and a driving principle of an electric vehicle according to the present disclosure.

Referring to FIG. 1, an electric vehicle 1 may include an on-board charger (OBC) 10, a high voltage DC-DC converter (HDC) 20, a low voltage direct current to direct current (DC-DC) converter (LDC) 30, a high voltage battery 40, a battery management system (BMS) 41, a low voltage battery 50, an inverter 60, and a motor 70.

The OBC 10 may be a converter for receiving external alternating current (AC) power 80 and performing AC-DC conversion, which may be a part for slowly charging the high voltage battery 40.

The HDC 20 may be a part for performing DC-DC conversion of power from the high voltage battery 40 and supplying the power to the inverter 60.

The LDC 30 may be a converter system for dropping DC power of the high voltage battery 40 to convert the DC power into 12V low-voltage power requested by various (e.g., most) parts of the vehicle, for example, headlights, wipers, a control unit, or the like and may supply the 12V low-voltage power to the low voltage battery 50.

The inverter 60 may be a power conversion device for driving the motor 70, which may be a part for converting DC into 3-phase AC to play a role in controlling a speed and a direction of the motor 70 and performing regenerative breaking.

The high voltage battery 40 may be charged by directly receiving power from a fast charger 90 for fast charging.

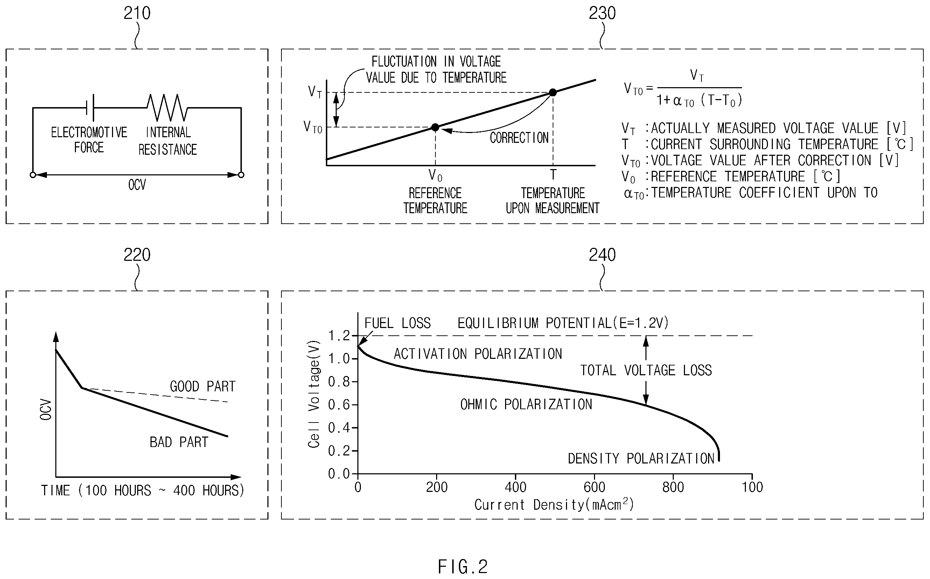

FIG. 2 is a drawing for describing the concept of an open circuit voltage (OCV) and polarization for calculating or otherwise determining a battery voltage according to an embodiment of the present disclosure.

As shown in a circuit diagram 210, the OCV may refer to a battery voltage when the battery is not connected with a load. In other words, the OCV may refer to a voltage measured at both ends of the battery in a state in which the circuit is open such that current does not flow in the battery. The battery may have self-discharge characteristics. An OCV value may be small according to the characteristics, but may be gradually degraded. For example, as shown in a plot 220, if there is a defect in the battery, self-discharge may increase.

The OCV of the battery may fluctuate due to temperature. Thus, it may be important to uniformly maintain a temperature environment when measuring the OCV. As shown in a plot 230, temperature correction may refer to converting an OCV measurement value into a voltage of a reference temperature.

It should be noted that, in a voltage change that occurs in a charging and discharging process to analyze performance of the battery, there may occur a phenomenon in which the voltage increases above the OCV upon charging and the voltage decreases below the OCV upon discharging. Polarization is the cause of the phenomenon.

The polarization refers to several phenomena that may occur in the surface of an electrode when the battery operates. The polarization may occur due to a factor such as a change in density at a reaction point or skinning. A voltage loss occurs due to this and this is called "overpotential" or a "polarization voltage". As the overpotential is larger, a larger voltage is required to obtain current. This has an influence on efficiency and performance of the battery.

A real voltage of the battery may be described as the sum of the OCV and the polarization voltage.

As shown in a plot 240, the polarization voltage may be composed of the sum of the following three elements.

1) Activation polarization: a voltage required to overcome an energy barrier for initiating electrochemical reaction
2) Density (or mass transfer) polarization: a voltage loss which occurs in the process of moving ions or electrons in the battery
3) Ohmic polarization: a voltage loss which occurs due to resistance of electrodes, electrolytes, and the other electrical components

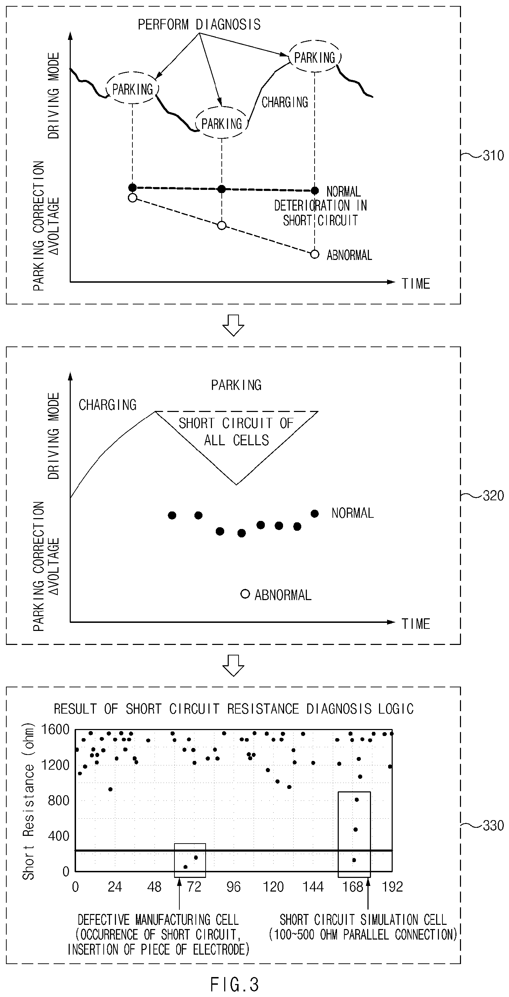

FIG. 3 is a drawing for describing a diagnosis process for discriminating or determining whether there is an abnormality in a battery cell, according to an embodiment of the present disclosure.

Referring to a plot 310 of FIG. 3, diagnosing whether there is abnormality in a battery cell may be performed during parking after vehicle driving ends or charging is completed. For example, a battery cell abnormality diagnosis process may be implemented to monitor an OCV change N times at a certain period, based on determining that a parking time is greater than or equal to a certain time.

As shown in a plot 320 of FIG. 3, an OCV change for each cell, which is measured during parking, may be converted into short circuit resistance based on a numerical model to ensure large resolution.

Referring to a plot 330 of FIG. 3, short circuit resistance calculated or otherwise determined for each cell may be compared with a certain threshold to diagnose whether there is an abnormality on a cell-by-cell basis. As an example, the diagnosed result may be the result of diagnosing a defective manufacturing cell, a short circuit simulation cell, and/or the like.

The battery cell abnormality diagnosis logic according to embodiments of the present disclosure may more accurately diagnose internal micro short circuit growth, which may be a main cause of a battery cell event, using improved diagnostic resolution in an initial stage.

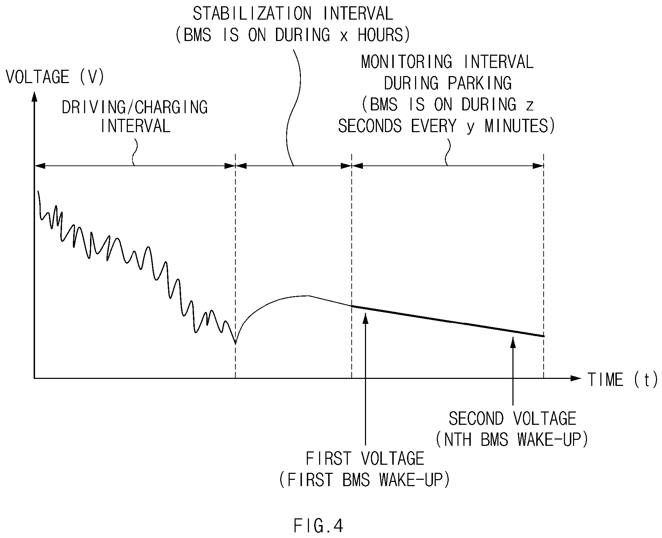

FIG. 4 is a drawing for describing a voltage extraction stage for diagnosing an abnormality in a battery cell, according to an embodiment of the present disclosure.

Referring to FIG. 4, when the driving or charging of a vehicle ends, a battery management system (BMS) may be maintained in an ON state during x hours to stabilize a battery voltage. When the battery voltage is stabilized, the BMS may enter a monitoring interval during parking of the vehicle to intermittently control the BMS to an ON state, for example, to maintain the BMS in the ON state during z seconds every y minutes, and may measure an OCV on a cell-by-cell basis. In an embodiment, a first voltage may be determined and stored in a memory based on a plurality of OCV values measured in a first BMS ON state after the BMS enters the monitoring interval during parking and a second voltage may be determined and stored in the memory based on a plurality of OCV values measured in an Nth BMS ON state.

It may be difficult to measure an accurate OCV in a BMS ON interval in which battery polarization remains. Low voltage (e.g., 12V or 48V) power may be used for the BMS and a low voltage battery may be charged using a high voltage battery if a state of charge (SOC) of the battery drops.

If vehicle driving resumes before the second voltage is extracted (or determined) because a parking time is short, the diagnostic process may end and the information stored in the memory may be deleted.

Battery cell abnormality diagnosis logic according to embodiments of the present disclosure may be implemented to wake up the BMS per specific time (e.g., according to a predetermined schedule) and measure a cell voltage to minimize power consumption in the monitoring interval during parking and calculate or otherwise determine a more accurate OCV.

In an example, determining the first voltage may be performed in a specific time during parking, rather than being performed at a time point when the parking ends.

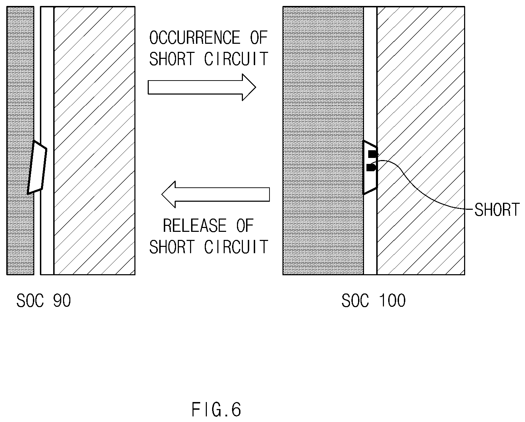

In general, if a micro short circuit occurs in a specific cell in the battery pack due, for example, to a piece of impurity, the SOC decreases (i.e., is lowered) by a leak current. In this case, as shown in FIG. 6, there may occur a situation in which the short circuit is released as the volume of an electrode plate in the battery becomes small.

If the short circuit and the short circuit release occur during parking (e.g., parking is for a sufficiently long time), because both of a time when the short circuit is maintained and a time when the short circuit is released are included in the calculation if the second voltage is calculated at a time point when the parking ends, the calculation may reflect the degree of the short circuit, that occurs relatively early, as being low. This may cause an error when short circuit resistance for diagnosing whether there is abnormality in battery cell is calculated.

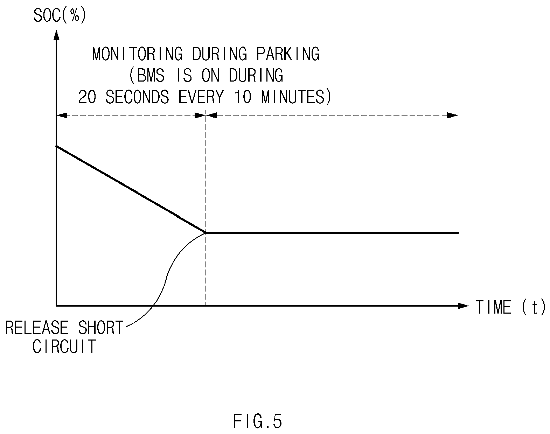

FIG. 5 is a drawing for describing voltage extraction logic in a monitoring interval during parking, according to an embodiment of the present disclosure.

Referring to FIG. 5, a BMS may be maintained in an ON state during z seconds every y minutes in the monitoring interval during the parking to measure a battery cell voltage. Voltage extraction logic according to embodiments of the present disclosure may be implemented such that a second voltage is determined (e.g., calculated) in a short circuit interval.

Because there is a process of dividing a time between a first voltage calculation time point and a second voltage calculation time point in the process of calculating the short circuit resistance, the short circuit resistance may be calculated to be smaller than the degree of the short circuit that actually occurs, if the second voltage is calculated at a time point after the short circuit is released.

The voltage extraction logic according to embodiments of the present disclosure may be implemented such that the second voltage is calculated after a specific time after the first voltage is calculated. This may prevent a problem in which the accuracy of measuring the voltage change is lowered due to a sufficiently large change in the temperature of the battery pack. In an embodiment, the specific time may be set to a time in which resolution of the voltage sensor does not cause misdiagnosis, for example, 6 hours or more. As described above, because the short circuit may be relieved and released over time, the certain time may be set to be within a time when the volume of the electrode is able to change after the short circuit, for example, within 24 hours.

FIG. 6 is a drawing for describing a short circuit and short circuit release process of a particular cell in a battery pack, according to an embodiment of the present disclosure.

FIG. 6 shows a situation in which a short circuit occurs due to a piece between cell electrode plates in a state in which a battery is fully charged, i.e., an SOC is 100%, the SOC decreases due to a leak current over time, and thus the short circuit is released as the volume of the electrode plate in the battery cell decreases.

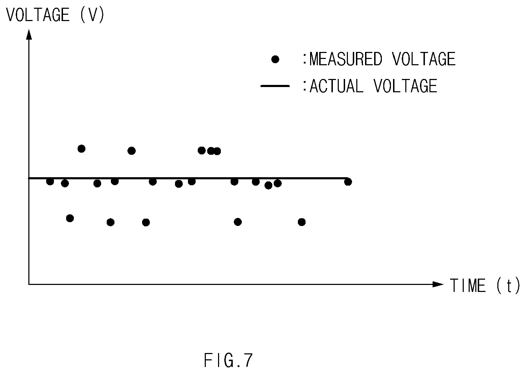

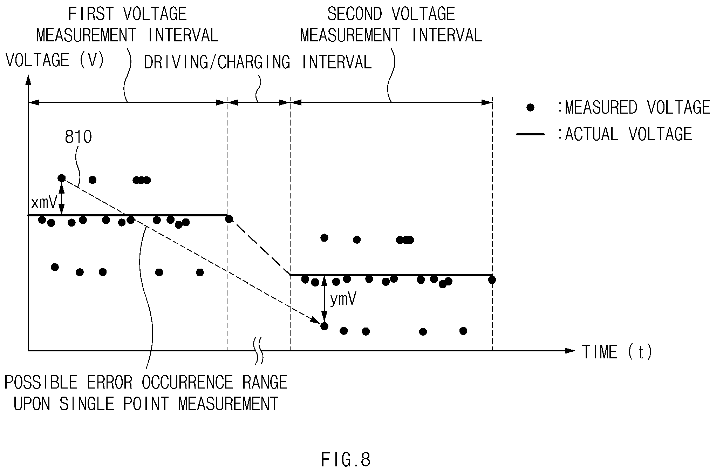

FIGS. 7 and 8 are drawings for describing a method for measuring a first voltage and a second voltage, according to an embodiment of the present disclosure.

When battery cell short circuit resistance is calculated, a small error in voltage measurement may show a large difference. As an example, in general, the measurement unit of a voltage sensor that may be used in an electric vehicle may be 1 mV, and a small error, e.g., 1 to 2 mV, in voltage measurement may cause a large error when short circuit resistance is calculated. This may greatly degrade the accuracy and confidence of diagnosing abnormality in a battery cell.

As shown in FIG. 7, the measured voltage may swing up and down by $\pm 1mV$ on the basis of an actual voltage. Thus, in an embodiment, the first voltage and the second voltage may be calculated or otherwise determined as an average value of a plurality of voltage values measured during a time interval to prevent occurrence of a measurement error.

Referring to FIG. 8, a first voltage measurement interval and a second voltage measurement interval may be spaced apart from each other by a specific time.

In an example, as shown in a plot 810, if each of the first voltage and the second voltage is determined as a voltage value measured at only one specific time point, a difference between the first voltage and the second voltage may be calculated to be 2 mV greater than or equal to an actual difference, e.g., +1 mv greater than or equal to the actual difference in the first voltage and -1 mV greater than or equal to the actual difference in the second voltage.

Voltage extraction logic according to embodiments of the present disclosure may determine a voltage corresponding to the voltage measurement interval as an average value of a plurality of measured voltage values in the voltage measurement interval to prevent misdiagnosis.

In an embodiment, if there is at least one value determined as abnormality in sensor among N measured values based on averaging N measured voltage values, a voltage of the voltage measurement interval fail to be calculated. However, this is only an example, and the present disclosure is not limited thereto. According to another embodiment, the voltage of the voltage measurement interval may be calculated as an average of the remaining voltage measurement intervals excluding the sensor abnormality value. In an embodiment, if the number of sensor abnormality values is greater than a certain reference value, the voltage of the voltage measurement interval is not calculated.

As an example, if the sensor value is out of a previous sensor value by specific amount (e.g., a specific number of mV) or more or is out of a normal range, it may be determined as abnormality in sensor.

Hereinafter, a short circuit resistance calculation procedure according to an embodiment of the present disclosure is described in more detail.

The short circuit resistance calculation procedure according to an embodiment may be roughly configured to include a capacity conversion stage, a power consumption correction stage, a time correction and leak current conversion stage, and a short circuit resistance conversion stage.

1) Capacity conversion stage

The first voltage and the second voltage calculated in the above-mentioned method may be converted into a first SOC and a second SOC, respectively, using a predefined OCV/SOC mapping table.

The first SOC and the second SOC may be multiplied by cell capacity and an SOH to be converted into first capacity and the second capacity.

Thereafter, a capacity change amount ΔmAh, which is a difference value between the first capacity and the second capacity, may be calculated. In an embodiment, if the calculated capacity change amount is negative, it may be converted into "0" to prevent an error in calculation.

2) Power consumption correction stage

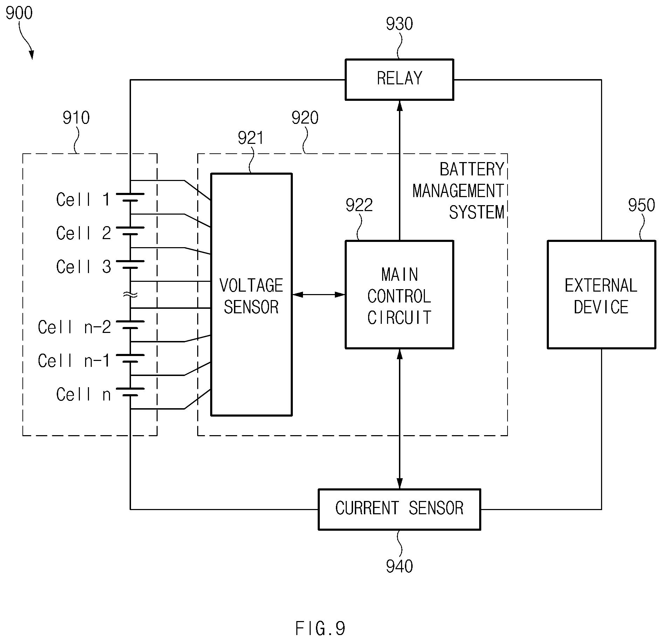

There may be power used by another logic (or device) in the vehicle, rather than power leaked by a short circuit between the first voltage and the second voltage, measured in a monitoring interval during parking. Thus, as the power used by the other logic (or device) in the vehicle is calculated and corrected, the leaked power Δleak_mAh may calculated according to Equation 1 below. Because, in an embodiment, battery cells are connected in series with each other as shown in FIG. 9, the same current flows in all cells, if power is used. Thus, default power consumption may be applied to all the cells in the same manner.

$$\Delta leak\_mAh = \Delta mAh - min(\Delta mAh) \quad <Equation\ 1>$$

In Equation 1, min(ΔmAh) refers to the minimum value among ΔmAh of each cell.

3) Time correction and leak current conversion stage

If an accessory (ACC) or the ignition is turned on between the time that first voltage and the time that the second voltage are measured in the monitoring interval during parking, the short circuit resistance calculation procedure may be implemented to count a corresponding time and not to count short circuit resistance because it is difficult to see that the vehicle is actually parked, and the used power may be calculated to be excessively large, if the counted time is greater than a certain reference time.

If the counted time is less than or equal to the certain reference time, the counted time may be added to a time between a first voltage measurement time and a second voltage measurement time to calculate a total measurement time T. As shown in Equation 2 below, the leaked power Δleak_mAh may be divided by the calculated total measurement time T to calculate corrected leak power leak mAh.

$$leak\_mAh = \Delta leak\_mAh\ /\ T \quad <Equation\ 2>$$

4) Short circuit resistance conversion stage

As shown in Equation 3 below, the corrected leak power leak_mAh may be divided by an average value, Ave_mV, of the first voltage and the second voltage to calculate short circuit resistance leak_Resistance.

$$leak\_Resistance = leak\_mAh / Ave\_mV \qquad <Equation\ 3>$$

Hereinafter, a battery cell abnormality diagnosis method and a threshold setting method therefor, according to an embodiment, are described in more detail.

A cell, the short circuit of which occurs, has a smaller OCV than other, normal, cells. A cell number of a cell in which a short circuit in a weak level, for example, less than 200 ohms occurs may be identified and stored. If a short circuit in the weak level is detected a certain number of times from the same cell, a system for diagnosing abnormality in battery cells may diagnose the cell as a micro short circuit cell indicating that a micro short circuit continuously occurs. If the cell in which the micro short circuit continuously occurs has the smallest OCV, the cell may be diagnosed as a minimum voltage micro short circuit cell.

If short circuit resistance of less than or equal to a certain level is detected at a specific temperature or SOC (in general, there is a large risk level as the short circuit resistance is smaller), a short circuit much worse than before may occur, if the temperature and the SOC increase upon a next driving cycle or charging. Thus, in an embodiment, a threshold setting for dynamically diagnosing an abnormal cell according to the temperature and the SOC may be provided.

As described above, because the short circuit of the battery may vary in size with the temperature and the SOC, as shown in Table 1 below, a threshold for diagnosing abnormality in battery cell may be differently defined according to a temperature and SOC condition.

<Table 1>

| Threshold (Unit: ohm) | SOC 20~60% | SOC 60~70% | SOC 70~80% | SOC 80~90% | SOC 90~100% |
|---|---|---|---|---|---|
| Temperature 0~15°C | 200 | 150 | 150 | 100 | 100 |
| Temperature 15~30°C | 150 | 150 | 100 | 100 | 50 |
| Temperature 30~55°C | 150 | 100 | 100 | 50 | 50 |

FIG. 9 is a drawing for describing a configuration of a system for diagnosing abnormality in battery cell according to an embodiment of the present disclosure.

Referring to FIG. 9, a system 900 for diagnosing an abnormality in a battery cell may include a battery 910, a battery management system 920, a relay 930, an external device 940, and a current sensor 950. In an embodiment, the battery management system 920 may include a computing device for pre-diagnosing safety of a battery. The computing device including a processor and a memory may compare short circuit resistance with a certain threshold to determine whether there is a micro short circuit of a corresponding cell.

The battery 910 may include, or be composed of, a plurality of cells. The plurality of cells may be connected in series with each other, for example. One end of the battery 910 may be connected with the relay 930 and the other end of the battery 910 may be connected with the current sensor 950.

The battery management system 920 may include a voltage sensor 921 and a main control circuit 922.

The voltage sensor 921 may measure a voltage of each cell of the battery 910 and may provide the main control circuit 922 with the measured voltage.

The main control circuit 922 may perform the above-mentioned battery cell abnormality diagnosis logic based on the voltage measurement value for each cell.

The main control circuit 922 may control the voltage sensor 921 to obtain the voltage measurement value for each cell, when entering a monitoring interval during parking, and may determine (e.g., calculate) the first voltage and the second voltage, as described above, based on the measured voltage values.

The main control circuit 922 may perform the above-mentioned short circuit resistance calculation procedure based on the first voltage and the second voltage to calculate short circuit resistance.

The main control circuit 922 may compare the calculated short circuit resistance with a certain threshold and may diagnose a cell in which a micro short circuit occurs.

The current sensor 950 may measure intensity of current flowing in the battery 910 and may provide the main control circuit 922 with the measured current.

The main control circuit 922 may receive current sensing information from the current sensor 950 to detect power used by the external device 940 and may determine and use a time when the power is used by the external device 940 to correct leak power.

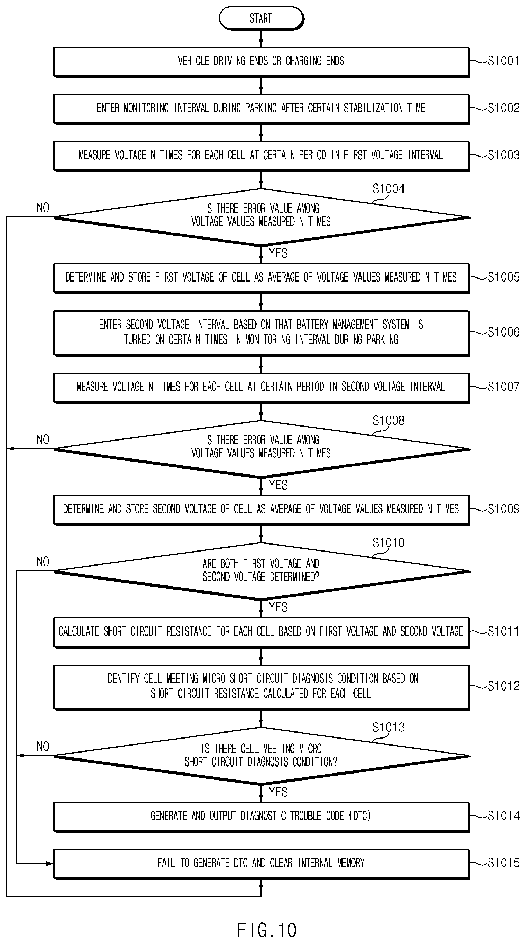

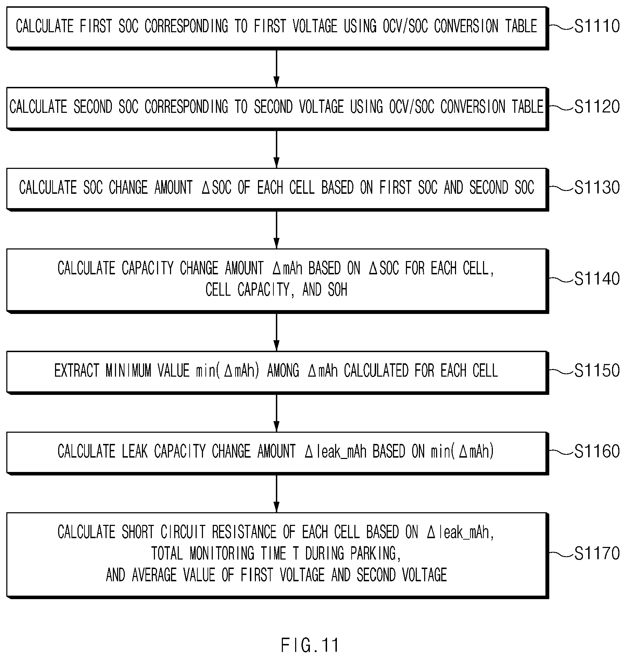

FIGS. 10 and 11 are flowcharts for describing a method for pre-diagnosing safety of an electric vehicle, according to an embodiment of the present disclosure.

In an embodiment, a method according to FIGS. 10 and 11 may be performed by the battery management system 920 of FIG. 9.

Referring to FIG. 10, in operations S1001 and S1002, when vehicle driving ends or charging ends, the battery management system 920 may enter a monitoring interval during parking after a certain stabilization time. In an embodiment, the battery management system 920 may wake up and be turned on at a certain time period after entering the monitoring interval during the parking. The battery management system 920 may count a wake-up count.

In an operation S1003, the battery management system 920 may measure a voltage N times for each cell at a certain period in a first voltage interval.

In an operation S1004, the battery management system 920 may determine whether there is an error value among the voltage values measured N times in the first voltage interval.

If there is no error value as a result of the determination, in an operation S1005, the battery management system 920 may determine and store a first voltage of the cell as an average of the voltage values measured N times for the first voltage interval.

In operations S1006 and S1007, the battery management system 920 may enter a second voltage interval based on that the battery management system 920 is turned on for a certain time (e.g., a certain amount of time or a certain number of times) in the monitoring interval during parking, and may measure a voltage N times for each cell in the second voltage interval.

In an operation S1008, the battery management system 920 may determine whether there is an error value among the voltage values measured N times in the second voltage interval.

If the battery management system 920 determines that there is no error value, in an operation S1009, the battery management system 920 may determine and store a second voltage of the cell as an average of the voltage values measured N times for the second voltage interval.

In an operation S1010, the battery management system 920 may determine whether both the first voltage and the second voltage are determined.

If the battery management system 920 determines that both the first voltage and the second voltage are determined, in an operation S1011, the battery management system 920 may calculate short circuit resistance for each cell based on the first voltage and the second voltage. Calculating the short circuit resistance for each cell, according to an embodiment, is described in more detail below with reference to FIG. 11.

In an operation S1012, the battery management system 920 may identify a cell meeting a micro short circuit diagnosis condition based on the short circuit resistance calculated for each cell. As an example, the battery management system 920 may determine a cell of which short circuit resistance is less than a certain threshold as the cell meeting the micro short circuit diagnosis condition. As the short circuit resistance is smaller in value, it is more dangerous.

In operations S1013 and S1014, if there is a cell meeting the micro short circuit diagnosis condition, the battery management system 920 may generate a fault code indicating that a micro short circuit is detected for the cell, for example, a diagnostic trouble code (DTC). In an embodiment, the generated fault code may be stored in an internal memory provided in the battery management system 920 and may be transmitted to an output means provided in a vehicle, for example a cluster, a head-up display, or audio video navigation (AVN), via inter-vehicle communication, for example controller area network (CAN) communication or local interconnect network (LIN) communication to be output as a warning alarm. However, this is only an example, and the present disclosure is not limited thereto. For example, according to another embodiment, the fault code may be transmitted to a diagnostic center (or a diagnostic server) via a mobile communication network, a dedicated vehicle wireless communication, or the like to be used when a vehicle is inspected and repaired.

If there is the error value as determined in the operation S1004 or the operation S1008, or at least one of the first voltage or the second voltage is not determined in the operation S1010, in an operation S1015, the battery management system 920 may fail to generate the fault code and may clear the internal memory to end the diagnosis of the abnormality in battery cell.

FIG. 11 is a flowchart for describing a method for determining (e.g., calculating) short circuit resistance for each cell among a plurality of cells of a battery pack, according to an embodiment of the present disclosure.

Referring to FIG. 11, in operations S1110 and S1120, the battery management system 920 may calculate or otherwise determine a first SOC and a second SOC respectively corresponding to a first voltage and a second voltage using a predefined OCV/SOC conversion table.

In an operation S1130, the battery management system 920 may calculate or otherwise determine an SOC change amount $\Delta$SOC of each cell based on the first SOC and the second SOC.

In an operation S1140, the battery management system 920 may calculate or otherwise determine a capacity change amount $\Delta$mAh based on $\Delta$SOC for each cell, cell capacity, and an SOH. In an embodiment, if $\Delta$mAh is negative, the battery management system 920 may convert or set the $\Delta$mAh to "0" to prevent an error in calculation.

In an operation S1150, the battery management system 920 may extract or otherwise determine a minimum value min($\Delta$mAh) among $\Delta$mAh calculated for the plurality of cells.

In an operation S1160, the battery management system 920 may calculate or otherwise determine a leak capacity change amount $\Delta$leak_mAh based on min($\Delta$mAh). In an embodiment, $\Delta$leak_mAh may be calculated as a value obtained by subtracting min($\Delta$mAh) from $\Delta$mAh. If $\Delta$leak_mAh is "0", the short circuit resistance value may be calculated as a specific large value, for example, 10,000 $\Omega$.

In an operation S1170, the battery management system 920 may calculate or otherwise determine short circuit resistance of each cell based on $\Delta$leak_mAh, a total monitoring time T during parking, and an average value of the first voltage and the second voltage. In an embodiment, the battery management system 920 may perform the above-mentioned time correction and leakage current conversion procedure to calculate the short circuit resistance.

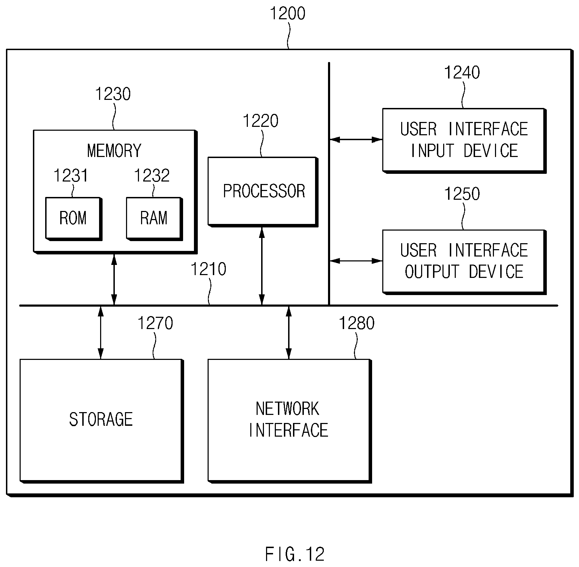

FIG. 12 illustrates a computing system according to an embodiment of the present disclosure.

Referring to FIG. 12, a computing system 1200 may include at least one processor 1220, a memory 1230, a user interface input device 1240, a user interface output device 1250, storage 1270, and a network interface 1280, which are connected with each other via a bus 1210.

The network interface 1280 according to an embodiment may perform at least one of diagnosis communication, inter-vehicle communication, and/or communication with an external server. The network interface 1280 may include a communication module (or a communication modem) for at least one of wired communication with an EV via a diagnosis cable, inter-vehicle communication for an inter-vehicle communication network, for example, CAN communication, or wireless communication via a mobile communication network.

The processor 1220 may be a central processing unit (CPU) or a semiconductor device that processes instructions stored in the memory 1230 and/or the storage 1270. The memory 1230 and the storage 1270 may include various types of volatile or non-volatile storage media. For example, the memory 1230 may include a ROM (Read Only Memory) 1231 and a RAM (Random Access Memory) 1232.

Thus, the operations of the method or the algorithm described in connection with the embodiments of the present disclosure may be embodied directly in hardware or a software module executed by the processor 1220, or in a combination thereof. The software module may reside on a storage medium (i.e., the memory 830 and/or the storage module 870) such as a RAM, a flash memory, a ROM, an EPROM, an EEPROM, a register, a hard disc, a removable disk, and a CD-ROM.

The storage medium may be coupled to the processor 1220. The processor 1220 may read out information from the storage medium and may write information in the storage medium. Alternatively, the storage medium may be integrated with the processor 1220. The processor and the storage medium may reside in an application specific integrated circuit (ASIC). The ASIC may reside within a user terminal. In another embodiment, the processor and the storage medium may reside as a separate component in the EV. However, this is only an example, and the present disclosure is not limited thereto. In an embodiment, the processor and the storage medium may reside in a battery management system.

According to some embodiments, the computing system 1200 may be implemented to perform at least one function and method disclosed in FIGS. 1-11 described above.

Embodiments of the present disclosure provide a method and an apparatus for pre-diagnosing the safety of the battery.

Furthermore, embodiments of the present disclosure may provide a method and an apparatus for pre-diagnosing the safety of the battery to calculate short circuit resistance based on a voltage change during parking in each of a plurality of battery cells and detect a battery cell defect.

Furthermore, embodiments of the present technology provide a method and an apparatus for pre-diagnosing the safety of the battery to improve diagnostic resolution to perform a numerical diagnosis via conversion of an OCV change into short circuit resistance upon parking during a certain time or more to more accurately diagnose micro short circuit growth of a battery cell in an initial stage.

In addition, various effects ascertained directly or indirectly through the present disclosure may be provided.

Hereinabove, although the present disclosure has been described with reference to example embodiments and the accompanying drawings, the present disclosure is not limited thereto. Rather, the present disclosure may be variously modified and altered by those having ordinary skill in the art to which the present disclosure pertains without departing from the spirit and scope of the present disclosure claimed in the appended claims.

Accordingly, embodiments of the present disclosure are intended not to limit but to explain the technical idea of the present disclosure, and the scope and spirit of the invention is not limited by the above embodiments. The scope of the present disclosure should be construed on the basis of the accompanying claims, and all the technical ideas within the scope equivalent to the claims should be included in the scope of the present disclosure.

## Claims

1. An apparatus for pre-diagnosing safety of a battery of a vehicle, the apparatus comprising:

   a memory configured to store computer-readable instructions; and

a processor configured to execute the computer-readable instructions,
wherein the processor is configured to
determine a first voltage and a second voltage for each cell, among a plurality of cells of the battery, during parking of the vehicle,
determine short circuit resistance for each cell, among the plurality of cells, based on the first voltage and the second voltage determined for each cell, and
determine whether there is a micro short circuit of each cell, among the plurality of cells, based on a comparison between the short circuit resistance determined for each cell and a threshold.

2. The apparatus of claim 1, wherein the processor is configured to:

average a plurality of voltage values measured during a first voltage interval to determine the first voltage; and
average a plurality of voltage values measured during a second voltage interval to determine the second voltage.

3. The apparatus of claim 2, wherein the second voltage interval is initiated after a specific time period after an end of the first voltage interval.

4. The apparatus of claim 2 or 3 wherein the processor is configured to end pre-diagnosing of safety of the battery based on determining that at least one of the plurality of voltage values is an error.

5. The apparatus of anyone of claims 2-4, wherein the processor is configured to average remaining voltage values, among the plurality of voltage values, excluding a voltage value that is determined to be an error, to determine the first voltage and the second voltage.

6. The apparatus of anyone of claims 1-5, wherein the processor is configured to:

enter a monitoring interval during the parking of the vehicle after a certain stabilization time elapses after driving of the vehicle ends or charging of the vehicle ends; and
determine the first voltage and the second voltage based on voltage measurements obtained in the monitoring interval.

7. The apparatus of anyone of claims 1-6, wherein the processor is configured to:

determine, for each cell among the plurality of cells, a first state of charge (SOC) and a second SOC respectively corresponding to the first voltage and the second voltage based on a predefined open circuit voltage(OCV)/SOC conversion table;
determine, for each cell among the plurality of cells, an SOC change amount based on the first SOC and the second SOC;
determine, for each cell among the plurality of cells, a capacity change amount based on the SOC change amount, cell capacity, and a state of health (SOH);
determine a minimum value among the capacity change amounts determined for the plurality of cells;
determine, for each cell among the plurality of cells, a leak capacity change amount based on the minimum value; and
determine, for each cell among the plurality of cells, the short circuit resistance based on the leak capacity change amount, a total monitoring time during the parking, and an average value of the first voltage and the second voltage.

8. The apparatus of claim 7, wherein the processor is configured to:

determine a time when one or both of an accessory (ACC) or an ignition is turned on during the parking; and
add the time to a total monitoring time based on determining that the time is less than a certain threshold time.

9. The apparatus of anyone of claims 1-8, wherein

the threshold is dynamically set based on a temperature and a state of charge (SOC) of the battery, and
the processor is configured to diagnose a cell among the plurality of cells, the short circuit resistance of which is less than the threshold, as a cell with the micro short circuit to generate a certain fault code.

10. The apparatus of anyone of claims 1-9, wherein the apparatus is implemented in a battery management system, and wherein the battery management system is intermittently turned on during the parking to measure a voltage for each cell.

11. A method for pre-diagnosing safety of a battery of a vehicle, the method comprising:

determining a first voltage and a second voltage for each cell, among a plurality of cells of the battery, during parking of the vehicle;
determining short circuit resistance for each cell, among the plurality of cells, based on the first voltage and the second voltage determined for each cell; and
determining whether there is a micro short circuit of each cell, among the plurality of cells, based on a comparison between the short circuit resistance determined each cell and a threshold.

12. The method of claim 11, wherein determining the short circuit resistance for each cell includes:

determining a first state of charge (SOC) and a second SOC respectively corresponding to the first voltage and the second voltage based on a predefined open circuit voltage(OCV)/SOC conversion table;
determining an SOC change amount based on the first SOC and the second SOC;
determining a capacity change amount based on the SOC change amount, cell capacity, and a state of health (SOH);
determining a minimum value among the capacity change amounts calculated for the plurality of cells;
determining a leak capacity change amount based on the minimum value; and
determining the short circuit resistance based on the leak capacity change amount, a total monitoring time during the parking, and an average value of the first voltage and the second voltage.

13. The method of claim 12, further comprising:

determining a time when one or both of an accessory (ACC) or an ignition is turned on during the parking; and
adding the time to the total monitoring time based on determining that the time is less than a threshold time.

14. The method of anyone of claims 11-13, wherein the threshold is dynamically set based on a temperature and a state of charge (SOC) of the battery, and
wherein a cell among the plurality of cells, the short circuit resistance of which is less than the threshold, is diagnosed as a cell with the micro short circuit to generate a certain fault code.

15. The method of anyone of claims 11-14, further comprising intermittently turning on a battery management system during the parking to measure a voltage for each cell.

**Amended claims in accordance with Rule 137(2) EPC.**

1. An apparatus for pre-diagnosing safety of a battery (910) of a vehicle (1), the apparatus comprising:

a memory configured to store computer-readable instructions; and
a processor configured to execute the computer-readable instructions,
wherein the processor is configured to

enter a monitoring interval during parking after a certain stabilization time elapses when vehicle driving ends or charging ends;
determine a first voltage and a second voltage for each cell, among a plurality of cells of the battery (910), during the monitoring interval,
determine short circuit resistance for each cell, among the plurality of cells, based on the first voltage and the second voltage determined for each cell determine, for each cell among the plurality of cells, a first state of charge (SOC) and a second SOC respectively corresponding to the first voltage and the second voltage based on a predefined open circuit voltage(OCV)/SOC conversion table;
determine, for each cell among the plurality of cells, an SOC change amount ($\Delta$SOC) based on the first SOC and the second SOC;
determine, for each cell among the plurality of cells, a capacity change amount ($\Delta$mAh) based on the SOC change amount ($\Delta$SOC), cell capacity, and a state of health (SOH);

determine a minimum value (min(ΔmAh)) among the capacity change amounts (ΔmAh) determined for the plurality of cells;

determine, for each cell among the plurality of cells, a leak capacity change amount (Δleak_mAh) based on the minimum value (min (ΔmAh)); and

determine, for each cell among the plurality of cells, the short circuit resistance based on the leak capacity change amount (Δleak_mAh), a total monitoring time (T) during the parking, and an average value of the first voltage and the second voltage; and

determine whether there is a micro short circuit of each cell, among the plurality of cells, based on a comparison between the short circuit resistance determined for each cell and a threshold.

2. The apparatus of claim 1, wherein the processor is configured to:

average a plurality of voltage values measured during a first voltage interval to determine the first voltage; and

average a plurality of voltage values measured during a second voltage interval to determine the second voltage.

3. The apparatus of claim 2, wherein the second voltage interval is initiated after a specific time period after an end of the first voltage interval.

4. The apparatus of claim 2 or 3 wherein the processor is configured to end pre-diagnosing of safety of the battery (910) based on determining that at least one of the plurality of voltage values is an error.

5. The apparatus of anyone of claims 2-4, wherein the processor is configured to average remaining voltage values, among the plurality of voltage values, excluding a voltage value that is determined to be an error, to determine the first voltage and the second voltage.

6. The apparatus of anyone of claims 1-5, wherein the processor is configured to:
determine the first voltage and the second voltage based on voltage measurements obtained in the monitoring interval.

7. The apparatus of claim 1, wherein the processor is configured to:

determine a time when one or both of an accessory (ACC) or an ignition is turned on during the parking; and

add the time to a total monitoring time (T) based on determining that the time is less than a certain threshold time.

8. The apparatus of anyone of claims 1-7, wherein

the threshold is dynamically set based on a temperature and a state of charge (SOC) of the battery (910), and

the processor is configured to diagnose a cell among the plurality of cells, the short circuit resistance of which is less than the threshold, as a cell with the micro short circuit to generate a certain fault code.

9. The apparatus of anyone of claims 1-8, wherein the apparatus is implemented in a battery management system (920), and

wherein the battery management system (920) is intermittently turned on during the parking to measure a voltage for each cell.

10. A method for pre-diagnosing safety of a battery (910) of a vehicle (1), the method comprising:

entering a monitoring interval during parking after a certain stabilization time elapses when vehicle driving ends or charging ends;

determining a first voltage and a second voltage for each cell, among a plurality of cells of the battery (910), during the monitoring interval;

determining, for each cell among the plurality of cells, a first state of charge (SOC) and a second SOC respectively corresponding to the first voltage and the second voltage based on a predefined open circuit voltage (OCV) /SOC conversion table;

determining, for each cell among the plurality of cells, an SOC change amount (ΔSOC) based on the first SOC and the second SOC;

determining, for each cell among the plurality of cells, a capacity change amount (ΔmAh) based on the SOC change amount (ΔSOC), cell capacity, and a state of health (SOH);

determining a minimum value (min($\Delta$mAh)) among the capacity change amounts ($\Delta$mAh) determined for the plurality of cells; determining, for each cell among the plurality of cells, a leak capacity change amount ($\Delta$leak_mAh) based on the minimum value (min($\Delta$mAh));

determining, for each cell among the plurality of cells, the short circuit resistance based on the leak capacity change amount ($\Delta$leak_mAh), a total monitoring time (T) during the parking, and an average value of the first voltage and the second voltage; and

determining whether there is a micro short circuit of each cell, among the plurality of cells, based on a comparison between the short circuit resistance determined each cell and a threshold.

11. The method of claim 10, further comprising:

determining a time when one or both of an accessory (ACC) or an ignition is turned on during the parking; and adding the time to the total monitoring time (T) based on determining that the time is less than a threshold time.

12. The method of anyone of claims 10-11, wherein the threshold is dynamically set based on a temperature and a state of charge (SOC) of the battery (910), and

wherein a cell among the plurality of cells, the short circuit resistance of which is less than the threshold, is diagnosed as a cell with the micro short circuit to generate a certain fault code.

13. The method of anyone of claims 10-12, further comprising intermittently turning on a battery management system (920) during the parking to measure a voltage for each cell.

FIG.1

210

ELECTROMOTIVE    INTERNAL
FORCE            RESISTANCE

OCV

230

FLUCTUATION IN VOLTAGE
VALUE DUE TO TEMPERATURE

$V_T$

$V_{T0}$

CORRECTION

$V_0$          T

REFERENCE      TEMPERATURE
TEMPERATURE    UPON MEASUREMENT

$$V_{T0} = \frac{V_T}{1 + \alpha_{T0}(T - T_0)}$$

$V_T$  : ACTUALLY MEASURED VOLTAGE VALUE [V]
$T$    : CURRENT SURROUNDING TEMPERATURE [℃]
$V_{T0}$ : VOLTAGE VALUE AFTER CORRECTION [V]
$V_0$  : REFERENCE TEMPERATURE [℃]
$\alpha_{T0}$ : TEMPERATURE COEFFICIENT UPON T0

220

OCV

GOOD PART

BAD PART

TIME (100 HOURS ~ 400 HOURS)

240

FUEL LOSS    EQUILIBRIUM POTENTIAL(E=1.2V)

1.2
1.0
0.8
0.6
0.4
0.2
0.0

Cell Voltage(V)

ACTIVATION POLARIZATION

TOTAL VOLTAGE LOSS

OHMIC POLARIZATION

DENSITY POLARIZATION

0      200     400     600     800     100

Current Density(mAcm²)

FIG.2

F I G.3

FIG.4

FIG.5

OCCURRENCE OF
SHORT CIRCUIT

RELEASE OF
SHORT CIRCUIT

SOC 90

SOC 100

SHORT

FIG.6

FIG.7

FIG.8

900

930

RELAY

910

920

921

922

BATTERY
MANAGEMENT
SYSTEM

950

Cell 1

Cell 2

Cell 3

Cell n-2

Cell n-1

Cell n

VOLTAGE
SENSOR

MAIN
CONTROL
CIRCUIT

EXTERNAL
DEVICE

CURRENT SENSOR

940

FIG.9

START

VEHICLE DRIVING ENDS OR CHARGING ENDS ～S1001

ENTER MONITORING INTERVAL DURING PARKING AFTER CERTAIN STABILIZATION TIME ～S1002

MEASURE VOLTAGE N TIMES FOR EACH CELL AT CERTAIN PERIOD IN FIRST VOLTAGE INTERVAL ～S1003

S1004
IS THERE ERROR VALUE AMONG VOLTAGE VALUES MEASURED N TIMES
NO
YES

DETERMINE AND STORE FIRST VOLTAGE OF CELL AS AVERAGE OF VOLTAGE VALUES MEASURED N TIMES ～S1005

ENTER SECOND VOLTAGE INTERVAL BASED ON THAT BATTERY MANAGEMENT SYSTEM IS TURNED ON CERTAIN TIMES IN MONITORING INTERVAL DURING PARKING ～S1006

MEASURE VOLTAGE N TIMES FOR EACH CELL AT CERTAIN PERIOD IN SECOND VOLTAGE INTERVAL ～S1007

S1008
IS THERE ERROR VALUE AMONG VOLTAGE VALUES MEASURED N TIMES
NO
YES

DETERMINE AND STORE SECOND VOLTAGE OF CELL AS AVERAGE OF VOLTAGE VALUES MEASURED N TIMES ～S1009

S1010
ARE BOTH FIRST VOLTAGE AND SECOND VOLTAGE DETERMINED?
NO
YES

CALCULATE SHORT CIRCUIT RESISTANCE FOR EACH CELL BASED ON FIRST VOLTAGE AND SECOND VOLTAGE ～S1011

IDENTIFY CELL MEETING MICRO SHORT CIRCUIT DIAGNOSIS CONDITION BASED ON SHORT CIRCUIT RESISTANCE CALCULATED FOR EACH CELL ～S1012

S1013
IS THERE CELL MEETING MICRO SHORT CIRCUIT DIAGNOSIS CONDITION?
NO
YES

GENERATE AND OUTPUT DIAGNOSTIC TROUBLE CODE (DTC) ～S1014

FAIL TO GENERATE DTC AND CLEAR INTERNAL MEMORY ～S1015

F I G . 10

CALCULATE FIRST SOC CORRESPONDING TO FIRST VOLTAGE USING OCV/SOC CONVERSION TABLE ~S1110

↓

CALCULATE SECOND SOC CORRESPONDING TO SECOND VOLTAGE USING OCV/SOC CONVERSION TABLE ~S1120

↓

CALCULATE SOC CHANGE AMOUNT ΔSOC OF EACH CELL BASED ON FIRST SOC AND SECOND SOC ~S1130

↓

CALCULATE CAPACITY CHANGE AMOUNT ΔmAh BASED ON ΔSOC FOR EACH CELL, CELL CAPACITY, AND SOH ~S1140

↓

EXTRACT MINIMUM VALUE min(ΔmAh) AMONG ΔmAh CALCULATED FOR EACH CELL ~S1150

↓

CALCULATE LEAK CAPACITY CHANGE AMOUNT Δleak_mAh BASED ON min(ΔmAh) ~S1160

↓

CALCULATE SHORT CIRCUIT RESISTANCE OF EACH CELL BASED ON Δleak_mAh, TOTAL MONITORING TIME T DURING PARKING, AND AVERAGE VALUE OF FIRST VOLTAGE AND SECOND VOLTAGE ~S1170

FIG.11

1200

MEMORY 1230

1231  1232

ROM  RAM

PROCESSOR 1220

1210

USER INTERFACE
INPUT DEVICE 1240

USER INTERFACE
OUTPUT DEVICE 1250

STORAGE 1270

NETWORK
INTERFACE 1280

FIG.12

# EUROPEAN SEARCH REPORT

**Application Number**

EP 25 17 9892

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 114 035 074 A (UNIV SHANGHAI SCIENCE & TECH) 11 February 2022 (2022-02-11) | 1-6,10, 11,15 | INV. G01R31/3835 G01R31/52 |
| A | * claim 1 * | 7-9, 12-14 | |
| | ----- | | |
| X | CN 116 125 311 A (HUANENG LANCANG RIVER HYDROPOWER CO LTD; HUANENG CLEAN ENERGY RES INST) 16 May 2023 (2023-05-16) * claim 1 * | 1,11 | |
| | ----- | | |

**TECHNICAL FIELDS SEARCHED (IPC)**

G01R

The present search report has been drawn up for all claims

| Place of search | Date of completion of the search | Examiner |
|---|---|---|
| Munich | 4 November 2025 | Dogueri, Ali Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 9892

This annex lists the patent family members relating to the patent documents cited in the above-mentioned European search report.
The members are as contained in the European Patent Office EDP file on
The European Patent Office is in no way liable for these particulars which are merely given for the purpose of information.

04-11-2025

| Patent document cited in search report | Publication date | Patent family member(s) | Publication date |
|---|---|---|---|
| CN 114035074 A | 11-02-2022 | NONE | |
| CN 116125311 A | 16-05-2023 | NONE | |

EPO FORM P0459

For more details about this annex : see Official Journal of the European Patent Office, No. 12/82

**EP 4 768 948 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240200927